(19) Europäisches Patentamt
European Patent Office
Office européen des brevets

(11) **EP 2 062 073 B1**

(12) **EUROPEAN PATENT SPECIFICATION**

(45) Date of publication and mention of the grant of the patent:
**08.10.2014 Bulletin 2014/41**

(21) Application number: **07837558.1**

(22) Date of filing: **30.08.2007**

(51) Int Cl.:
***G01V 3/32*** *(2006.01)*

(86) International application number:
**PCT/US2007/019105**

(87) International publication number:
**WO 2008/027491 (06.03.2008 Gazette 2008/10)**

(54) **NMR ECHO TRAIN COMPRESSION**

NMR-ECHOFOLGEKOMPRESSION

COMPRESSION DE TRAIN D'ECHO RMN

(84) Designated Contracting States:
**GB**

(30) Priority: **01.09.2006 US 841694 P**
**28.08.2007 US 845983**

(43) Date of publication of application:
**27.05.2009 Bulletin 2009/22**

(73) Proprietor: **BAKER HUGHES INCORPORATED**
**Houston TX 77210-4740 (US)**

(72) Inventors:
• **THERN, Holger, F.**
**30559 Hannover (DE)**

• **KRUSPE, Thomas**
**29342 Wienhausen (DE)**
• **HAMDAN, Mouin**
**Pieta, Malta (GB)**

(74) Representative: **Sloboshanin, Sergej et al**
**V. Füner, Ebbinghaus, Finck, Hano**
**Mariahilfplatz 3**
**81541 München (DE)**

(56) References cited:
**WO-A-2005/091018**    **GB-A- 2 343 959**
**US-A- 5 291 137**    **US-A- 5 363 041**
**US-A1- 2006 083 108**

**Description**

**BACKGROUND OF THE DISCLOSURE**

**1. Field of the Disclosure**

The present invention relates to a method of determining a property of an earth formation as well as to a corresponding apparatus and to a computer readable medium for use with such the apparatus, and more generally to determining geological properties of subsurface formations using Nuclear Magnetic Resonance ("NMR") methods for logging wellbores, particularly for representing NMR echo trains by a limited number of functional parameters, enabling efficient transmission of echo train from a downhole location.

**2. Description of the Related Art**

NMR methods are among the most useful non-destructive techniques of material analysis. When hydrogen nuclei are placed in an applied static magnetic field, a small majority of spins are aligned with the applied field in the lower energy s state, since the lower energy state is more stable than the higher energy state. The individual spins precess about the applied static magnetic field at a resonance frequency also termed as Larmor frequency. This frequency is characteristic to a particular nucleus and proportional to the applied static magnetic field. An alternating magnetic field at the resonance frequency in the Radio Frequency (RF) range, applied by a transmitting antenna to a subject or specimen in the static magnetic field flips nuclear spins from the lower energy state to the higher energy state. When the alternating field is turned off, the nuclei return to the equilibrium state with emission of energy at the same frequency as that of the stimulating alternating magnetic field. This RF energy generates an oscillating voltage in a receiver antenna whose amplitude and rate of decay depend on the physicochemical properties of the material being examined. The applied RF field is designed to perturb the thermal equilibrium of the magnetized nuclear spins, and the time dependence of the emitted energy is determine by the manner in which this system of spins return to equilibrium magnetization. The return is characterized by two parameters: $T_1$, the longitudinal or spin-lattice relaxation time; and $T_2$, the transverse or spin-spin relaxation time.

Measurements of NMR parameters of fluid filling the pore spaces of the earth formations such as relaxation times of the hydrogen spins, diffusion coefficient and/or the hydrogen density is the bases for NMR well logging. NMR well logging instruments can be used for determining properties of earth formations including the fractional volume of pore space and the fractional volume of mobile fluid filling the pore spaces of the earth formations.

One basic problem encountered in NMR logging or MRI imaging is the vast amount of data that has to be analyzed. In well logging with wireline instruments, the downhole processing capabilities are limited as is the ability to transmit data to an uphole location for further analysis since all the data are typically sent up a wireline cable with limited bandwidth. In the so-called Measurement-while-drilling methods, the problem is exacerbated due to the harsh environment in which any downhole processor must operate and to the extremely limited telemetry capability: data are typically transmitted at a rate of no more than twenty bits per second.

A second problem encountered in NMR logging and MRI imaging is that of analysis of the data. As will be discussed below, the problem of data compression and of data analysis are closely inter-related.

Methods of using NMR measurements for determining the fractional volume of pore space and the fractional volume of mobile fluid are described, for example, in Spin Echo Magnetic Resonance Logging: Porosity and Free Fluid Index Determination, M. N. Miller et al, Society of Petroleum Engineers paper no. 20561, Richardson, TX, 1990. In porous media there is a significant difference in T1 and T2 relaxation time spectrum of fluids mixture filling the pore space. Thus, for example, light hydrocarbons and gas may have T1 relaxation time of about several seconds, while T2 may be thousand times less. This phenomenon is due to diffusion effect in internal and external static magnetic field gradients. Internal magnetic field gradients are due to magnetic susceptibility difference between rock formation matrix and pore filling fluid.

Since oil is found in porous rock formation, the relationships between porous rocks and the fluids filling their pore spaces are extremely complicated and difficult to model. Nuclear magnetic resonance is sensitive to main petrophysical parameters, but has no capabilities to establish these complex relationships. Oil and water are generally found together in reservoir rocks. Since most reservoir rocks are hydrophilic, droplets of oil sit in the center of pores and are unaffected by the pore surface. The water-oil interface normally does not affect relaxation, therefore, the relaxation rate of oil is primarily proportional to its viscosity. However, such oil by itself is a very complex mixture of hydrocarbons that may be viewed as a broad spectrum of relaxation times.

In a simple case of pure fluid in a single pore, the are two diffusion regimes that govern the relaxation rate. Rocks normally have a very broad distribution of pore sizes and fluid properties. Thus it is not surprising that magnetization decays of fluid in rock formations are non-exponential. The most commonly used method of analyzing relaxation data is to calculate a spectrum of relaxation times. The Carr-Purcell-Meiboom-Gill (CPMG) pulse sequence is used to determine the transverse magnetization decay. The non-exponential magnetization decays are fit to the multi-exponential form:

$$M(t) = \sum_{i=1}^{L} m(T_{2i}) e^{-t/T_{2i}} \qquad\qquad (1)$$

where M(t) represents the spin echo amplitudes, equally spaced in time, and the $T_{2i}$ are predetermined time constants, equally spaced on a logarithm scale, typically between 0.3 ms and 3000 ms. The set of m are found using a regularized nonlinear least squares technique. The function $m(T_{2i})$, conventionally called a $T_2$ distribution, usually maps linearly to a volumetrically weighted distribution of pore sizes.

The calibration of this mapping is addressed in several publications. Prior art solutions seek a solution to the problem of mathematical modeling the received echo signals by the use of several techniques, including the use of non-linear regression analysis of the measurement signal; non-linear least square fit routines, as disclosed in U.S. Pat. No. 5,023,551 to Kleinberg et al, and others. Other prior art techniques include a variety of signal modeling techniques, such as polynomial rooting, singular value decomposition (SVD) and miscellaneous refinements thereof, to obtain a better approximation of the received signal. A problem with prior art signal compressions is that some information is lost.

Other methods of compression of NMR data are discussed, for example in U.S. Pat. No. 4,973,111 to Haacke and US Patent 5,363,041 to Sezginer. Inversion methods discussed in the two references generally are computationally intensive and still end up with a large number of parameters that have to be transmitted uphole. In particular, no simple methods have been proposed to take advantage of prior knowledge about the structure of the investigated material and the signal-to-noise (SNR) ratio of the received echo signal. Also, no efficient solutions have been proposed to combine advanced mathematical models with simple signal processing algorithms to increase the accuracy and numerical stability of the parameter estimates. Finally, existing solutions require the use of significant computational power which makes the practical use of those methods inefficient, and frequently impossible to implement in real-time applications.

## SUMMARY OF THE DISCLOSURE

The subject matter of the present invention is defined in claims 1, 6 and 12.

One embodiment of the disclosure is a method of determining a property of an earth formation. The method includes conveying a nuclear magnetic resonance (NMR) sensing apparatus into a borehole, using the NMR sensing apparatus for obtaining a signal indicative of the property of the earth formation, using a predetermined matrix to estimate from the signal a parametric representation of the relaxation of nuclear spins in terms of at least one basis function, telemetering the parametric representation to a surface location and, at the surface location, using the telemetered parametric representation to estimate the property of the earth formation. The signal may be a spin echo signal and representation of relaxation of nuclear spins may include a transverse relaxation time ($T_2$) distribution. The at least one basis function may be a Gaussian function, and parametric representation may include a mean, a standard deviation, and an amplitude of the Gaussian function. Defining the predetermined matrix may be done by for performing a regression analysis on synthetic NMR signals and/or NMR signals measured on samples having known properties. The dependent variable in the regression analysis may be a spin echo signal. The regression analysis may be a partial least-squares, a principal component regression, an inverse least-squares, a ridge regression, a Neural Network, a neural net partial least-squares regression, and/or a locally weighted regression. The determined property may be bound volume irreducible, effective porosity, bound water, clay-bound water, total porosity, a permeability, and/or a pore size distribution. The NMR sensing apparatus may be conveyed into the borehole on a bottomhole assembly using a drilling tubular.

Another embodiment of the disclosure is an apparatus for determining a property of an earth formation. The apparatus includes a nuclear magnetic resonance (NMR) sensing apparatus configured to be conveyed into a borehole and obtain a signal indicative of the property of the earth formation. The apparatus also includes a downhole processor configured to use a predetermined matrix to estimate from the signal a parametric representation of the relaxation of nuclear spins in terms of at least one basis function, telemeter the parametric representation to a surface location, and a surface processor configured to use with the telemetered parametric representation estimate the property of the formation. The signal that the NMR sensing apparatus is configured to produce may include a spin echo signal, and representation of relaxation of nuclear spins further may include a transverse relaxation time $T_2$ distribution. The at least one basis function that the downhole processor is configured to use may include a Gaussian function, and the parametric representation estimated by the downhole processor may include a mean, a standard deviation, and an amplitude of the Gaussian function. The predetermined matrix may be defined by a processor configured to perform regression analysis on synthetic NMR signals and/or NMR signals measured on samples having known properties. The dependent variable in the regression analysis may be a spin echo signal. The regression analysis the processor is configured to perform may include a partial least-squares, a principal component regression, inverse least-squares, ridge regression, Neural Networks, a neural net partial least-squares, and/or a locally weighted regression. The property the surface processor is configured to determine may be bound volume irreducible, effective porosity, bound water, clay-bound water, total porosity, a permeability, and/or a pore size distribution. The apparatus may include a drilling tubular configured to convey a bottomhole assembly including the NMR sensing device into the borehole.

Another embodiment of the disclosure is at least one computer-readable medium for use with an apparatus for determining a property of an earth formation. The apparatus includes a nuclear magnetic resonance (NMR) sensing apparatus configured to be conveyed into the borehole and produce a signal indicative of the property of the earth formation. The at least one computer readable medium includes instructions which enable a downhole processor to use a predetermined matrix estimate from the signal a parametric representation of relaxation of nuclear spins in terms of at least one basis function and telemeter the parametric representation to a surface location. Also included are instructions which enable a surface processor to use the telemetered parametric representation to estimate the property of the earth formation. The medium may be a ROM, an EPROM, an EEPROM, a flash memory, and/or an optical disk.

## BRIEF DESCRIPTION OF THE DRAWINGS

The present disclosure is best understood with reference to the accompanying figures in which like numerals refer to like elements and in which:

FIG. 1 (prior art) shows a measurement-while-drilling tool suitable for use with the present disclosure;
FIG. 2 (prior art) shows a sensor section of a measurement-while-drilling device suitable for use with the present disclosure;
FIGS. 3A and 3B show exemplary signals and reconstructed signals in the time domain and the $T_2$ domain respectively,
FIGS. 4A and 4B shows additional exemplary signals and reconstructed signals in the time domain and the $T_2$ domain respectively; and
FIG. 5 is a flow chart showing further details of the implementation of the disclosure.

## DETAILED DESCRIPTION OF THE DISCLOSURE

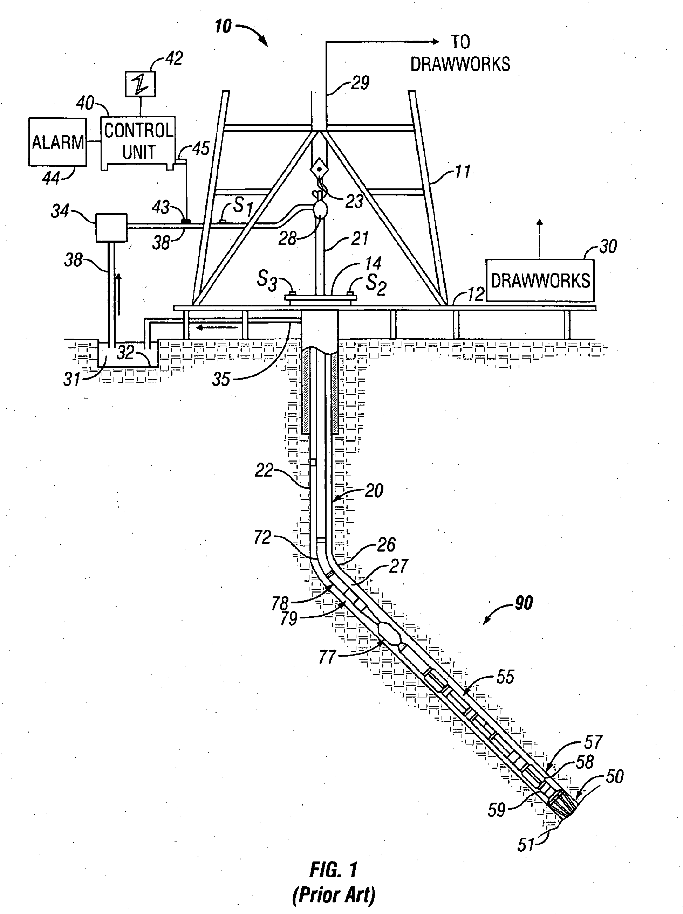

FIG. 1 shows a schematic diagram of a drilling system 10 with a drillstring 20 carrying a drilling assembly 90 (also referred to as the bottom hole assembly, or "BHA") conveyed in a "wellbore" or "borehole" 26 for drilling the wellbore. The drilling system 10 includes a conventional derrick 11 erected on a floor 12 which supports a rotary table 14 that is rotated by a prime mover such as an electric motor (not shown) at a desired rotational speed. The drillstring 20 includes a tubing such as a drill pipe 22 or a coiled-tubing extending downward from the surface into the borehole 26. The drillstring 20 is pushed into the wellbore 26 when a drill pipe 22 is used as the tubing. For coiled-tubing applications, a tubing injector, such as an injector (not shown), however, is used to move the tubing from a source thereof, such as a reel (not shown), to the wellbore 26. The drill bit 50 attached to the end of the drillstring breaks up the geological formations when it is rotated to drill the borehole 26. If a drill pipe 22 is used, the drillstring 20 is coupled to a drawworks 30 via a Kelly joint 21, swivel 28, and line 29 through a pulley 23. During drilling operations, the drawworks 30 is operated to control the weight on bit, which is an important parameter that affects the rate of penetration. The operation of the drawworks is well known in the art and is thus not described in detail herein. For the purposes of this disclosure, it is necessary to know the axial velocity (rate of penetration or ROP) of the bottomhole assembly. Depth information and ROP may be communicated downhole from a surface location. Alternatively, the method disclosed in U.S. Patent 6,769,497 to Dubinsky et al. having the same assignee as the present application and the contents of which are incorporated herein by reference may be used. The method of *Dubinsky* uses axial accelerometers to determine the ROP. During drilling operations, a suitable drilling fluid 31 from a mud pit (source) 32 is circulated under pressure through a channel in the drillstring 20 by a mud pump 34. The drilling fluid passes from the mud pump 34 into the drillstring 20 via a desurger (not shown), fluid line 38 and Kelly joint 21. The drilling fluid 31 is discharged at the borehole bottom 51 through an opening in the drill bit 50. The drilling fluid 31 circulates uphole through the annular space 27 between the drillstring 20 and the borehole 26 and returns to the mud pit 32 via a return line 35. The drilling fluid acts to lubricate the drill bit 50 and to carry borehole cutting or chips away from the drill bit 50. A sensor $S_1$ typically placed in the line 38 provides information about the fluid flow rate. A surface torque sensor $S_2$ and a sensor $S_3$ associated with the drillstring 20 respectively provide information about the torque and rotational speed of the drillstring. Additionally, a sensor (not shown) associated with line 29 is used to provide the hook load of the drillstring 20.

In one embodiment of the disclosure, the drill bit 50 is rotated by only rotating the drill pipe 22. In another embodiment of the disclosure, a downhole motor 55 (mud motor) is disposed in the drilling assembly 90 to rotate the drill bit **50** and the drill pipe **22** is rotated usually to supplement the rotational power, if required, and to effect changes in the drilling direction.

In an exemplary embodiment of **FIG. 1,** the mud motor **55** is coupled to the drill bit **50** via a drive shaft (not shown) disposed in a bearing assembly **57.** The mud motor rotates the drill bit **50** when the drilling fluid **31** passes through the mud motor **55** under pressure. The bearing assembly **57** supports the radial and axial forces of the drill bit. A stabilizer **58** coupled to the bearing assembly **57** acts as a centralizer for the lowermost portion of the mud motor assembly.

In one embodiment of the disclosure, a drilling sensor module **59** is placed near the drill bit **50.** The drilling sensor module contains sensors, circuitry and processing software and algorithms relating to the dynamic drilling parameters. Such parameters typically include bit bounce, stick-slip of the drilling assembly, backward rotation, torque, shocks, borehole and annulus pressure, acceleration measurements and other measurements of the drill bit condition. A suitable telemetry or communication sub **72** using, for example, two-way telemetry, is also provided as illustrated in the drilling assembly **90.** The drilling sensor module processes the sensor information and transmits it to the surface control unit **40** via the telemetry system **72.**

The communication sub **72,** a power unit **78** and an MWD tool **79** are all connected in tandem with the drillstring **20.** Flex subs, for example, are used in connecting the MWD tool **79** in the drilling assembly **90.** Such subs and tools form the bottom hole drilling assembly **90** between the drillstring **20** and the drill bit **50.** The drilling assembly **90** makes various measurements including the pulsed nuclear magnetic resonance measurements while the borehole **26** is being drilled. The communication sub **72** obtains the signals and measurements and transfers the signals, using two-way telemetry, for example, to be processed on the surface. Alternatively, the signals can be processed using a downhole processor in the drilling assembly **90.**

The surface control unit or processor **40** also receives signals from other downhole sensors and devices and signals from sensors $S_1$-$S_3$ and other sensors used in the system **10** and processes such signals according to programmed instructions provided to the surface control unit **40.** The surface control unit **40** displays desired drilling parameters and other information on a display/monitor **42** utilized by an operator to control the drilling operations. The surface control unit **40** typically includes a computer or a microprocessor-based processing system, memory for storing programs or models and data, a recorder for recording data, and other peripherals. The control unit **40** is typically adapted to activate alarms **44** when certain unsafe or undesirable operating conditions occur.

A suitable device for use of the present disclosure is disclosed in U.S. Patent 6,215,304 to Slade. It should be noted that the device taught by *Slade* is for exemplary purposes only, and the method of the present disclosure may be used with many other NMR logging devices, and may be used for wireline as well as MWD applications. Examples of such devices are given in U.S. patents 5,557,201 to Kleinberg, U.S. 5,280,243 to Miller, U.S. 5,055,787 to Kleinberg, and U.S. 5,698,979 to Taicher.

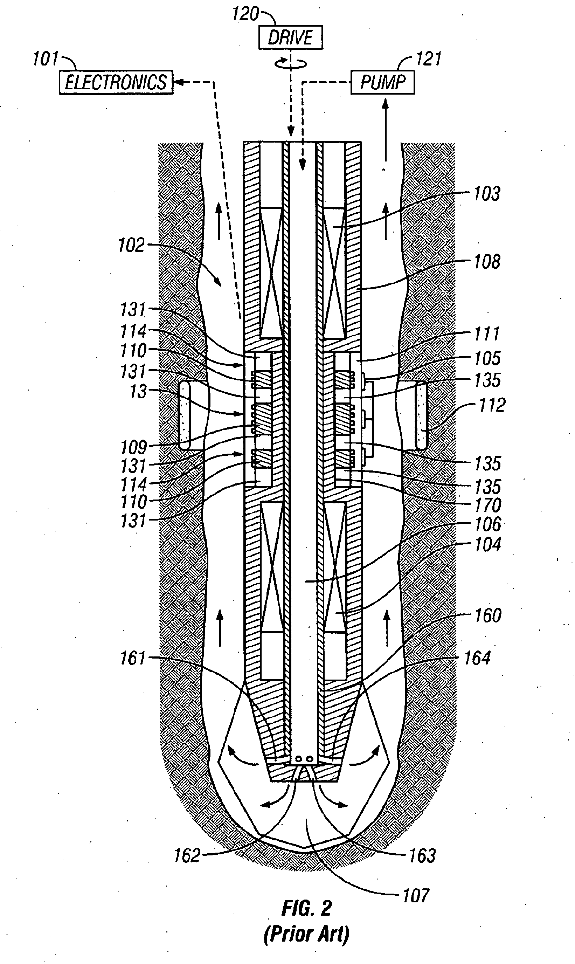

Referring now to **FIG. 2,** the tool has a drill bit 107 at one end, a sensor section **102** behind the drill head, and electronics **101.** The sensor section **102** comprises a magnetic field generating assembly for generating a $B_0$ magnetic field (which is substantially time invariant over the duration of a measurement), and an RF system for transmitting and receiving RF magnetic pulses and echoes. The magnetic field generating assembly comprises a pair of axially spaced main magnets **103,104** having opposed pole orientations (i.e. with like magnetic poles facing each other), and three ferrite members **109, 110** axially arranged between the magnets **103, 104.** The ferrite members are made of "soft" ferrite which can be distinguished over "hard" ferrite by the shape of the BH curve which affects both intrinsic coercivity ($H_j$ the intersection with the H axis) and initial permeability ($\mu_i$, the gradient of the BH curve in the unmagnetized case). Soft ferrite $\mu_i$ values typically range from 10 to 10000 whereas hard ferrite has $\mu_i$, of about 1. Therefore the soft ferrite has large initial permeability (typically greater than 10, preferably greater than 1000). The RF system comprises a set of RF transmit antenna and RF receive antenna coil windings 105 arranged as a central "field forming" solenoid group **113** and a pair of outer "coupling control" solenoid groups **114.**

The tool has a mud pipe **160** with a clear central bore **106** and a number of exit apertures **161-164** to carry drilling mud to the bit **107,** and the main body of the tool is provided by a drill collar **108.** Drilling mud is pumped down the mud pipe **160** by a pump **121** returning around the tool and the entire tool is rotated by a drive **120.** Coiled tubing or a drillstring may be used for coupling the drive to the downhole assembly.

The drill collar **108** provides a recess **170** for RF transmit antenna and RF receive antenna coil windings **105.** Gaps in the pockets between the soft ferrite members are filled with non-conducting material **131, 135** (e.g: ceramic or high temperature plastic) and the RF coils **113,114** are then wound over the soft ferrite members **109, 110.** The soft ferrites **109, 110** and RF coil assembly **113, 114** are pressure impregnated with suitable high temperature, low viscosity epoxy resin (not shown) to harden the system against the effects of vibration, seal against drilling fluid at well pressure, and reduce the possibility of magnetoacoustic oscillations. The RF coils **113, 114** are then covered with wear plates **111** typically ceramic or other durable non-conducting material to protect them from the rock chippings flowing upwards past the tool in the borehole mud.

Because of the opposed magnet configuration, the device of *Slade* has an axisymmetric magnetic field and region of investigation **112** that is unaffected by tool rotation. Use of the ferrite results in a region of investigation that is close to the borehole. This is not a major problem on a MWD tool because there is little invasion of the formation by borehole drilling fluids prior to the logging. The region of investigation is within a shell with a radial thickness of about 20 mm and an axial length of about 50 mm. The gradient within the region of investigation is less than 2.7 G/cm. It is to be noted that these values are for the *Slade* device and, as noted above, the method of the present disclosure may also be used with other suitable NMR devices.

The method of the present disclosure is based on a representation of the acquired echo train of the earth formation by several functional parameters. In one embodiment of the disclosure, these functions are Gaussian representations of the $T_2$ distribution, but this is not to be construed as a limitation of the disclosure, and other functional distributions may be used. These Gaussian distributions represent the expected different types of fluid in the formation. In a typical reservoir we can determine clay-bound water, capillary-bound water, movable water, and hydrocarbon as separate components. Each of the Gaussians is described by its amplitude, its width, and its mean. The functional parameters can be determined by different approaches. In one embodiment of the disclosure, a chemometric-based method such as a Partial Least Squares (PLS) method is used. This allows straightforward evaluation of the echo train into several parameters.

The principles of PLS are discussed, for example, in US 5,121,337 to Brown, the contents of which are incorporated herein by reference. The operations in PLS basically involve matrix multiplication and do not require inversion. The evaluation based on PLS models requires less memory space and execution time compared to the inversion and peak-fitting methods and can be easily implemented in a downhole system.

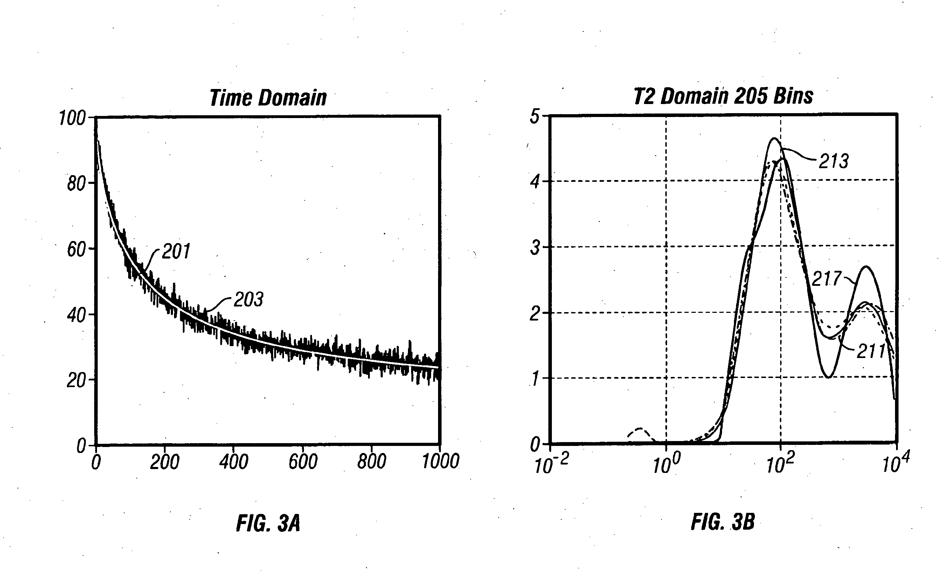

Turning now to **FIGS. 3A** and **3B,** an example of the use of the method is given. The curve **211** is a $T_2$ distribution that was used to generate a synthetic NMR spin-echo train denoted by **201** in **FIG. 3A.** Noise was added to the synthetic echo train to give the time domain data denoted by **203.** The curve **213** is the result of inverting the NMR echo train **203** using conventional inversion techniques. The curve **217** is a $T_2$ distribution obtained using the PLS method. The $T_2$ distribution in this case was modeled using 205 bins with the $T_2$ distribution by a plurality of Gaussian distributions. The parameters being fit are the mean, standard deviation and the amplitudes of the Gaussian distributions. In the examples shown, 3 - 5 Gaussian distributions were used.

Also shown in **FIG. 3A** but not visible due to the curve **203** are three additional curves. These additional curves are (i) a predicted echo train produced by the inverted $T_2$ distribution, and (ii) two predicted curves corresponding to the best fit Gaussian methods.

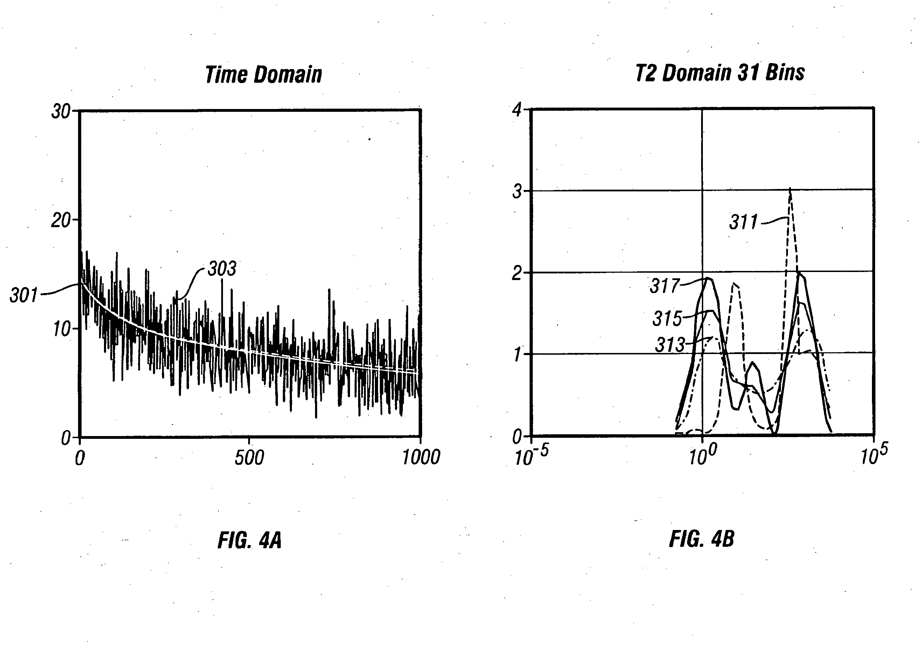

Turning now to **FIGS. 4A** and **4B,** similar modeling results are shown for a higher noise level and fewer bins (31) used in the $T_2$ domain. The curve **311** is the original $T_2$ distribution, corresponding to a noise-free synthetic echo train **301.** The curve **303** is a noisy version of the echo train 301. The curve **313** is the result of inverting the noisy echo train **303** using a prior art inversion method. The curve **315** is the result of the PLS method in which the mean, standard deviation and the amplitudes of the Gaussian distributions were free parameters. The curve **317** is the result of the PLS method in which the standard deviation and the amplitudes of the Gaussian distributions were free parameters. Time domain echo trains corresponding to **313, 315** and **317** are also shown in **FIG. 4A** but are hard to distinguish.

By the use of the Gaussian curve fitting, no more than 15 parameters have to be transmitted uphole (a maximum of three parameters for each of up to five Gaussian fits). This is a significant improvement over the transmission of one second of NMR data. At the surface, the estimated relaxation spectrum may be analyzed. For example, from the $T_2$ relaxation spectrum, using an inversion method it is possible to estimate the pore-size distribution. The use of a pore-scale geometric model used in inverting NMR spectra is described, for example, in US Patent Pub. No. 2006/0273788 A1 of Georgi et al. The Gaussians can be used to reconstruct both the original echo train (without noise) and the corresponding representation in $T_2$ domain which then can be used to derive all further properties of interest as it is typically done in the oilfield industry.

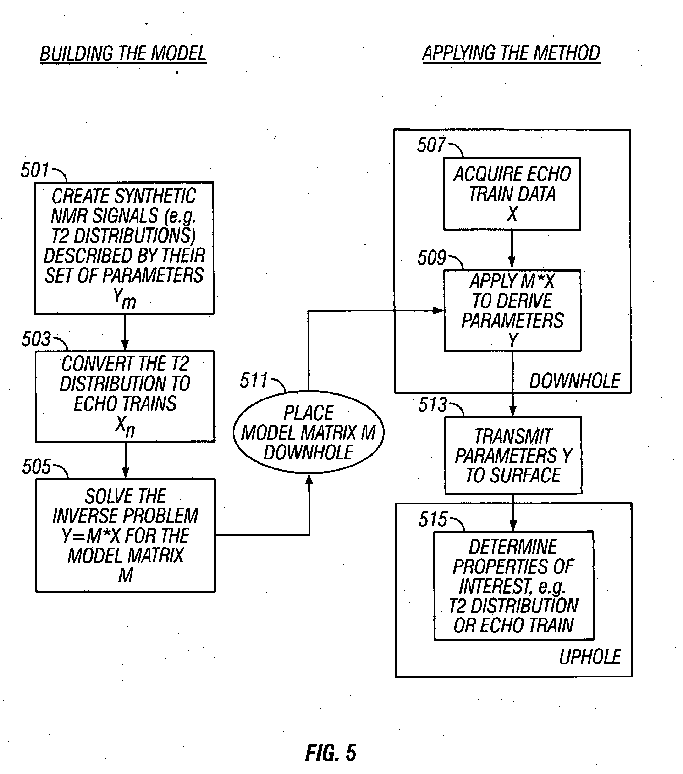

Turning now to **FIG. 5,** a flow chart summarizing the implementation of the method, including further details of the fitting method described above is shown. The first phase **501** of building the model involves creating synthetic NMR signals, e.g.,$T_2$ distributions, described by their set of parameters $\mathbf{Y_m}$ The $T_2$ distributions are converted 503 using known methods to echo trains $\mathbf{X_n}$. It should be noted that the number of samples in the echo train *n* should be greater than or equal to the number *m* of parameters characterizing the $T_2$ distribution. This may be denoted by the equation:

$$Y = MX \qquad\qquad (1).$$

Eqn. (1) is inverted (discussed above and below) to give $\hat{M}$, the estimated inverse of M. The steps upto and including the determination of the inverse matrix M may be done at a surface location. The determined inverse matrix is stored on a memory of a processor in the BHA **511** and conveyed downhole.

NMR data are acquired downhole 507. Applying 509 the inverse matrix $\hat{M}$ to the acquired echo train X gives an estimate of parameters Y that characterize the acquired echo train. Steps **507, 509** are carried out downhole. The estimated parameters Y are transmitted to the surface **513**. The number of bits required to do this transmission is considerably less than the number of bits that would be required to transmit the entire echo train X or a conventional $T_2$ distribution. This is an important consideration in mud pulse telemetry where bandwidth is a severe limitation. At the surface, the properties of interest, such as the echo train itself or a $T_2$ distribution of the echo train are reconstructed. Note that the operations performed downhole needed to compress the data involve only a simple matrix multiplication. The reconstruction of the $T_2$ distribution simply involves Gaussian functions.

As an alternative or a supplement to creating synthetic echo trains, actual measurements of echo trains may be made or laboratory on known samples whose properties are known, or NMR data from a rock catalog may be used for driving the inverse matrix $\hat{M}$.

The parameters $Y_m$ can be multiple Gaussian distributions where each Gaussian is described by 3 parameters. See examples in **FIGS. 4A** and **4B**. The parameters for each Gaussian distribution are:

the mean $\mu_i$ of the $T_2$ location [ms];
the amplitude $A_i$ amplitude [p.u.]; and
the standard deviation $\sigma_i$.

Instead of Gaussian distributions, other basis functions may be used with corresponding parameters.

Solving the inverse problem Y=M*X can be done by different methods such as partial least-squares (PLS), principal component regression (PCR), inverse least- squares (ILS), or ridge regression (RR). Further discussion of these methods is disclosed in WO 2005/091018 A1 to Hamdan et al. For non-linear problems Neural Networks, neural net partial least-squares (NNPLS), locally weighted regression (LWR), or other methods can be used.

An important point of difference between *Hamdan* and the present disclosure is that in the former, the independent variable for the regression is a formation property. In the present disclosure, the independent variables for the regression are parameters that provide an efficient representation of the echo train (for telemetering), such as parameters of a $T_2$ distribution that, in a least-squares sense, replicates the echo train.

The recreation of properties of interest may cover $T_2$ distribution, volumetrics, permeability, echo trains, and other rock and fluid properties that are based on NMR data. It should further be noted that the method itself is of course not limited to downhole applications, As noted in *Hamdan,* bound volume irreducible, effective porosity, bound water, clay-bound water, and total porosity are among the formation properties that may be determined. As noted in *Georgi,* it is possible to estimate the pore size distribution..Determination of permeability is discussed in US 6,686,736 to SchoenI et al.

Implicit in the control and processing of the data is the use of a computer program implemented on a suitable machine readable medium that enables the processor to perform the control and processing. The machine readable medium may include ROMs, EPROMs, EAROMs, Flash Memories and Optical disks.

While the foregoing disclosure is directed to the specific embodiments of the disclosure, various modifications will be apparent to those skilled in the art.

**Claims**

1. A method of determining a property of an earth formation, the method comprising:

- conveying a nuclear magnetic resonance (NMR) sensing apparatus into a borehole (26);
- using the NMR sensing apparatus for obtaining a signal indicative of the property of the earth formation;
- defining a predetermined matrix by performing a regression analysis on at least one of: synthetic NMR signals, and NMR signals measured on samples having known properties **characterized by**
- at a downhole location, using the predetermined matrix to estimate from the signal by a matrix multiplication a parametric representation of relaxation of nuclear spins in terms of at least one basis function;
- telemetering the parametric representation to a surface location; and
- at the surface location, using the telemetered parametric representation to estimate the property of the earth formation.

2. The method of claim 1, wherein:

- the signal comprises a spin echo signal (203, 303), and
- the representation of relaxation of nuclear spins comprises a transverse relaxation time (T2) distribution (211, 311).

3. The method of claim 1, wherein:

   - the at least one basis function comprises a Gaussian function, and
   - the parametric representation includes a mean, a standard deviation, and an amplitude of the Gaussian function.

4. The method of claim 1, wherein the determined property is at least one of: bound volume irreducible, effective porosity, bound water, clay-bound water, total porosity, a permeability, and a pore size distribution.

5. The method of claim 1, further comprising conveying the NMR sensing apparatus into the borehole (26) on a bottomhole assembly (90) using a drilling tubular.

6. An apparatus for determining a property of an earth formation, the apparatus comprising a nuclear magnetic resonance (NMR) sensing apparatus configured to be conveyed into a borehole (26) and obtain a signal indicative of the property of the earth formation;
   **characterized by**

   - a processor configured to define a predetermined matrix by performing a regression analysis on at least one of: synthetic NMR signals, and NMR signals measured on samples having known properties,
   - a downhole processor configured to:

     o use the predetermined matrix to estimate from the signal by a matrix multiplication, a parametric representation of relaxation of nuclear spins in terms of at least one basis function, and
     o telemeter the parametric representation to a surface location; and

   - a surface processor configured to use the telemetered parametric representation to estimate the property of the earth formation.

7. The apparatus of claim 6, wherein:

   - the signal that the NMR sensing apparatus is configured to produce comprises a spin echo signal (203, 303), and
   - the representation of relaxation of nuclear spins further comprises transverse relaxation time $T_2$ distribution (211, 311).

8. The apparatus of claim 6, wherein:

   - the at least one basis function the downhole processor is configured to use comprises a Gaussian function, and
   - the parametric representation the downhole processor is configured to estimate includes a mean, a standard deviation, and an amplitude of the Gaussian function.

9. The apparatus of claim 6, wherein a dependent variable in the regression analysis comprises a spin echo signal (203, 303).

10. The apparatus of claim 6, wherein the regression analysis the processor is configured to perform is selected from the group consisting of: partial least-squares, principal component regression, inverse least-squares, ridge regression, Neural Networks, neural net partial least-squares, and locally weighted regression.

11. The apparatus of claim 6, further comprising a drilling tubular configured to convey a bottomhole assembly (90) including the NMR sensing device into the borehole (26).

12. A computer readable medium for use with an apparatus for determining a property of an earth formation, the apparatus comprising:

   - a processor configured to define a predetermined matrix by performing a regression analysis on at least one of: synthetic NMR signals, and NMR signals measured on samples having known properties, and
   - a nuclear magnetic resonance (NMR) sensing apparatus configured to be conveyed into a borehole (26) and obtain a signal indicative of the property of the earth formation; **characterized by**
   the computer readable medium including instructions which:
   - enable a downhole processor to:

o use the predetermined matrix to estimate from the signal by a matrix multiplication, a parametric representation of relaxation of nuclear spins in terms of at least one basis function, and
o telemeter the parametric representation to a surface location; and

- enable a surface processor to use the telemetered parametric representation to estimate the property of the earth formation.

13. The at least one medium of claim 12, wherein the medium is selected from the group consisting of a ROM, an EPROM, an EEPROM, a flash memory, and an optical disk.

**Patentansprüche**

1. Verfahren zur Bestimmung einer Eigenschaft einer Erdformation, wobei das Verfahren umfasst:

- Fördern einer Nuklearmagnetresonanz(NMR)-Erfassungsvorrichtung in ein Bohrloch (26);
- Verwenden der NMR-Erfassungsvorrichtung zum Erhalten eines Signals, das für die Eigenschaft der Erdformation indikativ ist;
- Definieren einer vorherbestimmten Matrix durch Durchführung einer Regressionsanalyse an wenigstens einem aus: synthetischen NMR-Signalen und NMR-Signalen, die an Proben mit bekannten Eigenschaften gemessen wurden,
**gekennzeichnet durch**
- Verwenden der vorherbestimmten Matrix an einer Stelle im Bohrloch, um aus dem Signal durch eine Matrixmultiplikation eine parametrische Darstellung der Relaxation der Kernspins hinsichtlich wenigstens einer Basisfunktion zu schätzen;
- Telemetrieren der parametrischen Darstellung zu einem Ort an der Oberfläche; und
- Verwenden der telemetrierten parametrischen Darstellung an dem Ort an der Oberfläche, um die Eigenschaft der Erdformation zu schätzen.

2. Verfahren nach Anspruch 1, wobei:

- das Signal ein Spin-Echo-Signal (203, 303) umfasst und
- die Darstellung der Relaxation der Kernspins eine Querrelaxation-Zeit (T2)-Verteilung (211, 311) umfasst.

3. Verfahren nach Anspruch 1, wobei:

- die wenigstens eine Basisfunktion eine Gauss'sche Funktion umfasst und
- die parametrische Darstellung einen Mittelwert, eine Standardabweichung und eine Amplitude der Gauss'schen Funktion einschließt.

4. Verfahren nach Anspruch 1, wobei die bestimmte Eigenschaft wenigstens eine ist von:

gebundenes irreduzibles Volumen, effektive Porosität, gebundenes Wasser, tongebundenes Wasser, totale Porosität, eine Permeabilität und eine Porengrößeverteilung.

5. Verfahren nach Anspruch, das weiterhin das Fördern einer NMR-Erfassungsvorrichtung in das Bohrloch (26) an einer Bohrlochsöhlenanordnung (90) unter Verwendung einer Bohrverrohrung umfasst.

6. Vorrichtung zur Bestimmung einer Eigenschaft einer Erdformation, wobei die Vorrichtung eine Nuklearmagnetresonanz(NMR)-Erfassungsvorrichtung umfasst, die dazu ausgelegt ist, in ein Bohrloch (26) gefördert zu werden und ein Signal zu empfangen, das für die Eigenschaft der Erdformation indikativ ist;
**gekennzeichnet durch**

- einen Prozessor, der dazu konfiguriert ist, eine vorherbestimmte Matrix zu definieren, indem er eine Regressionsanalyse durchführt an wenigstens einem aus: synthetischen NMR-Signalen und NMR-Signalen, die an Proben mit bekannten Eigenschaften gemessen wurden,
- einen Prozessor im Bohrloch, der dazu konfiguriert ist:

◦ die vorherbestimmte Matrix zu verwenden, um aus dem Signal **durch** eine Matrixmultiplikation eine parametrische Darstellung der Relaxation der Kernspins hinsichtlich wenigstens einer Basisfunktion zu schätzen; und

◦ die parametrische Darstellung zu einem Ort an der Oberfläche zu telemetrieren; und

- einen Prozessor an der Oberfläche, der dazu konfiguriert ist, die telemetrierte parametrische Darstellung zu verwenden, um die Eigenschaft der Erdformation zu schätzen.

**7.** Vorrichtung nach Anspruch 6, wobei:

- das Signal, zu dessen Erzeugung die Nuklearmagnetresonanz(NMR)-Erfassungsvorrichtung ausgelegt ist, ein Spin-Echo-Signal (203, 303) umfasst und
- die Darstellung der Relaxation der Kernspins weiterhin eine Querrelaxation-Zeit-$T_2$-Verteilung (211, 311) umfasst.

**8.** Vorrichtung nach Anspruch 6, wobei:

- die wenigstens eine Basisfunktion, zu deren Verwendung der Prozessor im Bohrloch konfiguriert ist, eine Gauss'sche Funktion umfasst und
- die parametrische Darstellung, zu deren Schätzung der Prozessor im Bohrloch konfiguriert ist, einen Mittelwert, eine Standardabweichung und eine Amplitude der Gauss'schen Funktion einschließt.

**9.** Vorrichtung nach Anspruch 6, wobei eine abhängige Variable in der Regressionsanalyse ein Spin-Echo-Signal (203, 303) umfasst.

**10.** Vorrichtung nach Anspruch 6, wobei die Regressionsanalyse, zu deren Durchführung der Prozessor konfiguriert ist, aus der Gruppe ausgewählt ist, die besteht aus: partielle kleinste Quadrate, Hauptkomponentenregression, inverse kleinste Quadrate, Ridge-Regression, Neurale Netze, Neuralnetz-Partiellkleinstquadrate und lokal gewichtete Regression.

**11.** Vorrichtung nach Anspruch 6, die weiterhin eine Bohrverrohrung umfasst, die dazu ausgelegt ist, eine Bohrlochsohlenanordnung (90) einschließlich der NMR-Erfassungsvorrichtung in das Bohrloch (26) zu fördern.

**12.** Computerlesbares Medium zur Verwendung mit einer Vorrichtung zur Bestimmung einer Eigenschaft einer Erdformation, wobei die Vorrichtung umfasst:

- einen Prozessor, der dazu konfiguriert ist, eine vorherbestimmte Matrix zu definieren, indem er eine Regressionsanalyse durchführt an wenigstens einem aus: synthetischen NMR-Signalen und NMR-Signalen, die an Proben mit bekannten Eigenschaften gemessen wurden, und
- eine Nuklearmagnetresonanz(NMR)-Erfassungsvorrichtung umfasst, die dazu konfiguriert ist, in ein Bohrloch (26) gefördert zu werden und ein Signal zu empfangen, das für die Eigenschaft der Erdformation indikativ ist; **dadurch gekennzeichnet, dass**
das computerlesbare Medium Befehle umfasst, die
- es einem Prozessor im Bohrloch ermöglichen:

◦ die vorherbestimmte Matrix zu verwenden, um aus dem Signal durch eine Matrixmultiplikation eine parametrische Darstellung der Relaxation der Kernspins hinsichtlich wenigstens einer Basisfunktion zu schätzen; und
◦ die parametrische Darstellung zu einem Ort an der Oberfläche zu telemetrieren; und

- es einem Prozessor an der Oberfläche ermöglichen, die telemetrierte parametrische Darstellung zu verwenden, um die Eigenschaft der Erdformation zu schätzen.

**13.** Wenigstens ein Medium nach Anspruch 12, wobei das Medium aus der Gruppe ausgewählt ist, die aus einem ROM, einem EPROM, einem EEPROM, einem Flash-Memory und einer optischen Platte besteht.

**Revendications**

1. Procédé de détermination d'une propriété d'une formation terrestre, le procédé comprenant les étapes consistant à :

   - amener un appareil de détection par résonance magnétique nucléaire (RMN) dans un trou de forage (26) ;
   - utiliser l'appareil de détection par RMN pour obtenir un signal indiquant la propriété de la formation terrestre ;
   - définir une matrice prédéterminée en réalisant une analyse de régression sur au moins un parmi : des signaux RMN synthétiques, et des signaux RMN mesurés sur des échantillons présentant des propriétés connues, **caractérisé par** les étapes consistant à :
   - au niveau d'un emplacement de fond de puits, utiliser la matrice prédéterminée pour estimer, à partir du signal et grâce à une multiplication matricielle, une représentation paramétrique de relaxation de spins nucléaires selon au moins une fonction-base ;
   - télémesurer la représentation paramétrique par rapport à un emplacement de surface ; et
   - au niveau de l'emplacement de surface, utiliser la représentation paramétrique télémesurée pour estimer la propriété de la formation terrestre.

2. Procédé selon la revendication 1, dans lequel :

   - le signal comprend un signal d'écho de spin (203, 303), et
   - la représentation de relaxation de spins nucléaires comprend une distribution (211, 311) de temps (T2) de relaxation transversale.

3. Procédé selon la revendication 1, dans lequel ;

   - la au moins une fonction-base comprend une fonction gaussienne, et
   - la représentation paramétrique comprend une moyenne, un écart standard, et une amplitude de la fonction gaussienne.

4. Procédé selon la revendication 1, dans lequel la propriété déterminée est au moins une propriété parmi : volume lié irréductible, porosité effective, eau liée, argile et eau liées, porosité totale, perméabilité, et distribution de la taille des pores.

5. Procédé selon la revendication 1, comprenant en outre une étape consistant à amener l'appareil de détection par RMN dans le trou de forage (26) sur un assemblage de fond de puits (90) en utilisant des tubulaires de forage.

6. Appareil permettant de déterminer une propriété d'une formation terrestre, l'appareil comprenant un appareil de détection par résonance magnétique nucléaire (RMN) configuré pour être amené dans un trou de forage (26) et obtenir un signal indiquant la propriété de la formation terrestre ;
   **caractérisé par**

   - un processeur configuré pour définir une matrice prédéterminée en réalisant une analyse de régression sur au moins un parmi : des signaux RMN synthétiques, et des signaux RMN mesurés sur des échantillons présentant des propriétés connues,
   - un processeur de fond de puits configuré pour :

     o utiliser la matrice prédéterminée pour estimer, à partir du signal et grâce à 'une multiplication matricielle, une représentation paramétrique de relaxation de spins nucléaires selon au moins une fonction-base, et
     o télémesurer la représentation paramétrique par rapport à un emplacement de surface ; et

   - un processeur de surface configuré pour utiliser la représentation paramétrique télémesurée pour estimer la propriété de la formation terrestre.

7. Appareil selon la revendication 6, dans lequel :

   - le signal que l'appareil de détection par RMN est configuré pour produire comprend un signal d'écho de spin (203, 303), et
   - la représentation de la relaxation de spins nucléaires comprend en outre une distribution (211, 311) de temps $T_2$ de relaxation transversale.

8. Procédé selon la revendication 6, dans lequel :

   - la au moins une fonction-base que le processeur de fond de puits est configuré pour utiliser comprend une fonction gaussienne, et
   - la représentation paramétrique que le processeur de fond de puits est configuré pour estimer comprend une moyenne, un écart standard, et une amplitude de la fonction gaussienne.

9. Appareil selon la revendication 6, dans lequel une variable dépendante dans l'analyse de régression comprend un signal d'écho de spin (203, 303).

10. Appareil selon la revendication 6, dans lequel l'analyse de régression que le processeur est configuré pour réaliser est sélectionnée parmi le groupe constitué de : méthode des moindres carrés partiels, régression de composantes principales, méthode inverse des moindres carrés, régression de type ridge, modèle de réseaux neuronaux, méthode des moindres carrés partiels avec modèle neuronal, et régression pondérée localement.

11. Appareil selon la revendication 6, comprenant en outre des tubulaires de forage configurés pour amener un assemblage de fond de puits (90) comprenant le dispositif de détection par RMN dans le puits de forage (26).

12. Support pouvant être lu par un ordinateur pour une utilisation avec un appareil permettant de déterminer une propriété d'une formation terrestre, l'appareil comprenant :

   - un processeur configuré pour définir une matrice prédéterminée en réalisant une analyse de régression sur au moins un parmi : des signaux RMN synthétiques, et des signaux RMN mesurés sur des échantillons présentant des propriétés connues, et
   - un appareil de détection par résonance magnétique nucléaire (RMN) configuré pour être amené dans un puits de forage (26) et obtenir un signal indiquant la propriété de la formation terrestre ; **caractérisé par**

   **Le fait que** le support pouvant être lu par un ordinateur comprend des instructions qui :

   - permettent à un processeur de fond de puits de :

      o utiliser la matrice prédéterminée pour estimer, à partir du signal et grâce à une multiplication matricielle, une représentation paramétrique de relaxation de spins nucléaires selon au moins une fonction-base, et
      o télémesurer la représentation paramétrique par rapport à un emplacement de surface ; et

   - permettent à un processeur de surface d'utiliser la représentation paramétrique télémesurée pour estimer la propriété de la formation terrestre.

13. Au moins un support selon la revendication 12, dans lequel le support est sélectionné parmi le groupe constitué d'une ROM, d'une EPROM, d'une EEPROM, d'une mémoire flash, et d'un disque optique.

**FIG. 1**
**(Prior Art)**

**FIG. 2**
**(Prior Art)**

**Time Domain**

**FIG. 3A**

**T2 Domain 205 Bins**

**FIG. 3B**

**Time Domain**

**T2 Domain 31 Bins**

*FIG. 4A*

*FIG. 4B*

EP 2 062 073 B1

**BUILDING THE MODEL**

**APPLYING THE METHOD**

501 — CREATE SYNTHETIC NMR SIGNALS (e.g. T2 DISTRIBUTIONS) DESCRIBED BY THEIR SET OF PARAMETERS $Y_m$

503 — CONVERT THE T2 DISTRIBUTION TO ECHO TRAINS $X_n$

505 — SOLVE THE INVERSE PROBLEM Y=M*X FOR THE MODEL MATRIX M

511 — PLACE MODEL MATRIX M DOWNHOLE

507 — ACQUIRE ECHO TRAIN DATA X

509 — APPLY M*X TO DERIVE PARAMETERS Y

DOWNHOLE

513 — TRANSMIT PARAMETERS Y TO SURFACE

515 — DETERMINE PROPERTIES OF INTEREST, e.g. T2 DISTRIBUTION OR ECHO TRAIN

UPHOLE

**FIG. 5**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5023551 A, Kleinberg
- US 4973111 A, Haacke
- US 5363041 A, Sezginer
- US 6769497 B, Dubinsky
- US 6215304 B, Slade
- US 5557201 A, Kleinberg
- US 5280243 A, Miller
- US 5055787 A, Kleinberg
- US 5698979 A, Taicher
- US 5121337 A, Brown
- US 20060273788 A1, Georgi
- WO 2005091018 A1, Hamdan
- US 6686736 B, Schoenl

**Non-patent literature cited in the description**

- **M. N. MILLER et al.** Spin Echo Magnetic Resonance Logging: Porosity and Free Fluid Index Determination. *Society of Petroleum Engineers paper no. 20561,* 1990